# EUROPÄISCHE PATENTSCHRIFT

(11) **EP 3 377 855 B1**
(45) Veröffentlichungstag und Bekanntmachung des Hinweises auf die Patenterteilung: **18.09.2019**
(21) Anmeldenummer: 16793903.2
(22) Anmeldetag: 10.11.2016
(51) Int. Cl.: G01C 19/5712, G01C 19/5747

(54) **MIKROMECHANISCHER DREHRATENSENSOR UND VERFAHREN ZU DESSEN HERSTELLUNG**
MICROMECHANICAL YAW RATE SENSOR AND METHOD FOR THE PRODUCTION THEREOF
CAPTEUR DE VITESSE DE LACET MICROMÉCANIQUE ET SON PROCÉDÉ DE FABRICATION

(30) Priorität: 20.11.2015 DE 102015222943; 28.07.2016 DE 102016213870
(43) Veröffentlichungstag der Anmeldung: 26.09.2018
(73) Patentinhaber: Robert Bosch GmbH, 70442 Stuttgart (DE)
(72) Erfinder: NEUL, Reinhard, 70567 Stuttgart (DE); OHMS, Torsten, 71665 Vaihingen/Enz-Aurich (DE); MAUL, Robert, 75181 Pforzheim (DE); HATTASS, Mirko, 70191 Stuttgart (DE); HOEPPNER, Christian, 70197 Stuttgart (DE); PRUETZ, Odd-Axel, 72622 Nuertingen (DE); SCHMIDT, Benjamin, 70499 Stuttgart (DE); SCHEBEN, Rolf, 72762 Reutlingen (DE); HEUCK, Friedjof, 70193 Stuttgart (DE)
(86) Internationale Anmeldenummer: PCT/EP2016/077214
(87) Internationale Veröffentlichungsnummer: WO 2017/084950

(56) Entgegenhaltungen:
- EP-A1- 2 884 229
- WO-A1-00/19169
- WO-A1-97/02467
- DE-A1-102009 027 897
- DE-A1-102012 219 511

## Beschreibung

Die vorliegende Erfindung bezieht sich auf einen mikromechanischen Drehratensensor, insbesondere auf einen Drehratensensor mit einem Rotationsschwinger. Unter einem weiteren Gesichtspunkt bezieht sich die Erfindung auf ein Verfahren zum Herstellen eines derartigen mikromechanischen Drehratensensors.

### Stand der Technik

Mikromechanische Drehratensensoren werden im Automobilbereich z.B. in ESP-Systemen, zur Überrollsensierung oder zu Navigationszwecken eingesetzt. Die Aufgabe des Drehratensensors ist die korrekte Messung der Fahrzeugbewegung um eine Drehachse.

WO 00/19169 A1 beschreibt einen mikromechanischen Drehratensensor mit einem Rotationsschwinger.

WO 97/02467 A1 beschreibt einen Drehratensensor, insbesondere einen Coriolis- Drehratensensor, mit einer auf einem Grundelement drehbeweglich aufgehängten Schwingstruktur, an der durch eine extern einwirkende Drehrate eine Drehimpulsänderung bewirkbar ist.

DE 10 2012 219511 A1 beschreibt einen Drehratensensor mit einem eine Haupterstreckungsebene aufweisenden Substrat zur Detektion einer ersten Drehrate um eine sich senkrecht zur Haupterstreckungsebene erstreckenden ersten Richtung und zur Detektion einer zweiten Drehrate um eine sich parallel zur Haupterstreckungsebene erstreckenden zweiten Richtung, wobei die mikromechanische Struktur ein zu einer Drehschwingung um eine Drehachse parallel zur ersten Richtung angetriebenes Drehschwingelement aufweist.

Die Druckschrift DE 10 2009 027 897 A1 offenbart einen mikromechanischen Drehratensensor mit einem scheibenförmigen Rotationsschwinger, der sich in der durch ein Chipsubstrat definierten x-y-Ebene erstreckt und der in eine rotierende Oszillation um eine senkrecht auf dieser Ebene stehenden Drehachse (z-Achse) versetzt wird. Der Rotationsschwinger ist über vier Federn mit einer Nabe verbunden. Die Federn sind in einer kreisförmigen mittigen Aussparung des Rotationsschwingers, in welchen die Nabe hineinragt, angeordnet. Das dem Rotationsschwinger entgegen gerichtete Ende der Nabe ist fest am Substrat angeordnet.

Erfährt der Drehratensensor während einer Drehbewegung des Schwingkörpers um die Schwingachse eine Drehung um eine sensitive Achse (z.B. x-Achse) des Drehratensensors, so wirken auf die Schwingachse Corioliskräfte, welche eine Verkippung des Schwingkörpers gegenüber einer Oberfläche des Substrats bewirken. Die Verkippung des Rotationsschwingers kann mit Hilfe von Messelektroden kapazitiv detektiert und ausgewertet werden.

Für eine zuverlässige Erfassung der Drehrate ist es wünschenswert, bei geringer Baugröße die durch einen Schwingantrieb auf den Rotationsschwinger übertragene rotierende Oszillation weitestmöglich von der durch die Corioliskräfte hervorgerufenen Verkippung zu entkoppeln.

### Offenbarung der Erfindung

Die vorliegende Erfindung stellt einen mikromechanischen Drehratensensor mit den Merkamlen des Anspruchs 1, und ein Verfahren zum Herstellen eines mikromechanischen Drehratensensors mit den Merkmalen des Anspruchs 8 zur Verfügung.

Die vorliegende Erfindung schafft gemäß einem ersten Aspekt einen mikromechanischen Drehratensensor, der einen Rotationsschwinger mit einem Rotationsschwinglager aufweist. Das Rotationsschwinglager umfasst einen Wippbalken, einen Wippfederstab, der den Wippbalken federnd mit einem Substrat des Drehratensensors verbindet, und zwei Lagerungsfederstäbe, die auf entgegengesetzten Seiten des Wippfederstabs den Wippbalken federnd mit dem Rotationsschwinger verbinden.

Erfindungsgemäß verläuft der Wippfederstab senkrecht zum Wippbalken. Dies ermöglicht eine besonders zuverlässige Detektion der Verkippung des Rotationsschwingers durch gleichmäßigen Antrieb der schwingenden Oszillation mit großer Amplitude.

Erfindungsgemäß verlaufen die Lageruhgsfederstäbe parallel zum Wippfederstab. Dies ermöglicht, die Lagerungsfederstäbe in einer gleichen Kristallrichtung des Substrats wie den Wippfederstab auszubilden, um auf diese Weise eine Kopplung zwischen der Antriebsmode und der Detektionsmode besonders zuverlässig zu unterdrücken.

Gemäß einem weiteren Aspekt schafft die vorliegende Erfindung ein Verfahren zum Herstellen eines mikromechanischen Drehratensensors mit einem Rotationsschwinger, welches das Ausbilden eines Rotationsschwinglagers einschließt. Das Ausbilden des Rotationsschwinglagers umfasst die Schritte: Ausbilden eines Wippbalkens; Federndes Verbinden des Wippbalkens und eines Substrats des Drehratensensors mittels eines Wippfederstabs; und Federndes Verbinden des Wippbalkens und des Rotationsschwingers mittels zweier Lagerungsfederstäbe auf entgegengesetzten Seiten des Wippfederstabs.

### Vorteile der Erfindung

Die Struktur des Rotationsschwinglagers ermöglicht bei kompakter Bauweise eine hochgradig lineare Antriebsmode, bei der Störmoden (durch Kopplung vom Antrieb auf eine detektierbare Verkippung des Rotationsschwingers übertragene unerwünschte Schwingungen) bei Frequenzen auftreten, die wesentlich höher sind als die Antriebsfrequenz, sodass aufgrund der Störmoden einem detektierten Verkippungssignal gegebenenfalls überlagerte Störungen durch einfache Maßnahmen wie z.B. Tiefpassfilterung mit einer Grenzfrequenz oberhalb der Antriebsfrequenz zuverlässig unterdrückt werden können.

Gemäß einer bevorzugten Weiterbildung sind die Lagerungsfederstäbe symmetrisch auf den entgegengesetzten Seiten des Wippfederstabs ausgebildet. Hierdurch wird in der Antriebsmode eine besonders gleichmäßige, harmonische Rotationsschwingung ermöglicht.

Gemäß einer bevorzugten Weiterbildung umfasst der Drehratensensor ferner eine erste Antriebsmasse, die neben dem Rotationsschwinger angeordnet und über eine erste Feder an den Rotationsschwinger gekoppelt ist, sowie eine zweite Antriebsmasse, die neben dem Rotationsschwinger angeordnet und über eine zweite Feder an den Rotationsschwinger gekoppelt ist, wobei der Wippfederstab sich entlang einer Verbindungsgerade zwischen der ersten und zweiten Feder erstreckt. Dies ermöglicht eine Detektionsmode, bei welcher der Rotationsschwinger um die Verbindungsgerade kippt und dabei nur eine minimale Verformung des Wippfederstabs sowie der ersten und zweiten Feder erfordert. So wird bei wirksamer Entkopplung von der Antriebsmode eine besonders große Auslenkung in der Detektionsmode ermöglicht.

Gemäß einer bevorzugten Weiterbildung umfasst das Rotationsschwinglager ferner einen weiteren Wippbalken, einen weiteren Wippfederstab, der den weiteren Wippbalken federnd mit dem Substrat des Drehratensensors verbindet, sowie zwei weitere Lagerungsfederstäbe, die auf entgegengesetzten Seiten des weiteren Wippfederstabs den weiteren Wippbalken federnd mit dem Rotationsschwinger verbinden. Hierdurch wird in der Antriebsmode eine besonders stabile, gleichmäßige und harmonische Rotationsschwingung ermöglicht, da der Rotationsschwinger durch das Rotationsschwinglager mittels mehr als einem Wippbalken gestützt wird. Vorzugsweise sind der Wippfederstab und der weitere Wippfederstab kollinear ausgebildet, z.B. in symmetrischer Ausbildung. Dies ermöglicht eine Detektionsmode, bei welcher der Rotationsschwinger um die durch den Wippfederstab und den weiteren Wippfederstab verlaufende Gerade kippt und dabei nur eine minimale Verformung beider erfordert.

Vorzugsweise weist der Rotationsschwinger einen ersten Vorsprung und einen zweiten Vorsprung auf, die in einer Aussparung des Rotationsschwingers gebildet sind, wobei von den beiden Lagerungsfederstäben einer den Wippbalken mit dem ersten Vorsprung verbindet, während der andere Lagerungsfederstab den Wippbalken mit dem zweiten Vorsprung verbindet, und von den beiden weiteren Lagerungsfederstäben einer den weiteren Wippbalken mit dem ersten Vorsprung verbindet, während der andere weitere Lagerungsfederstab den weiteren Wippbalken mit dem zweiten Vorsprung verbindet. Dies ermöglicht u. a. eine besonders platzsparende Ausbildung des Rotationsschwingers. Weiterhin bevorzugt sind der erste und zweite Vorsprung an einander gegenüberliegenden Seiten der Aussparung gebildet wobei der Wippfederstab den Wippbalken und der weitere Wippfederstab den weiteren Wippbalken mit dem Substrat des Drehratensensors zwischen dem ersten und zweiten Vorsprung verbindet. Dies erlaubt auf besonders einfache und platzsparende Weise, sowohl den Wippbalken als auch den weiteren Wippbalken mit einem gemeinsamen, als Nabe fungierenden Substratverankerungspunkt zu verbinden.

### Kurze Beschreibung der Zeichnungen

Es zeigen:
Fig. 1 eine schematische Draufsicht auf einen mikromechanischen Drehratensensor gemäß einer Ausführungsform der Erfindung, wobei feststehende Teile nicht gezeigt sind; und
Fig. 2 ein Flussdiagramm eines Betriebsverfahrens für einen mikromechanischen Drehratensensor gemäß einer Ausführungsform.

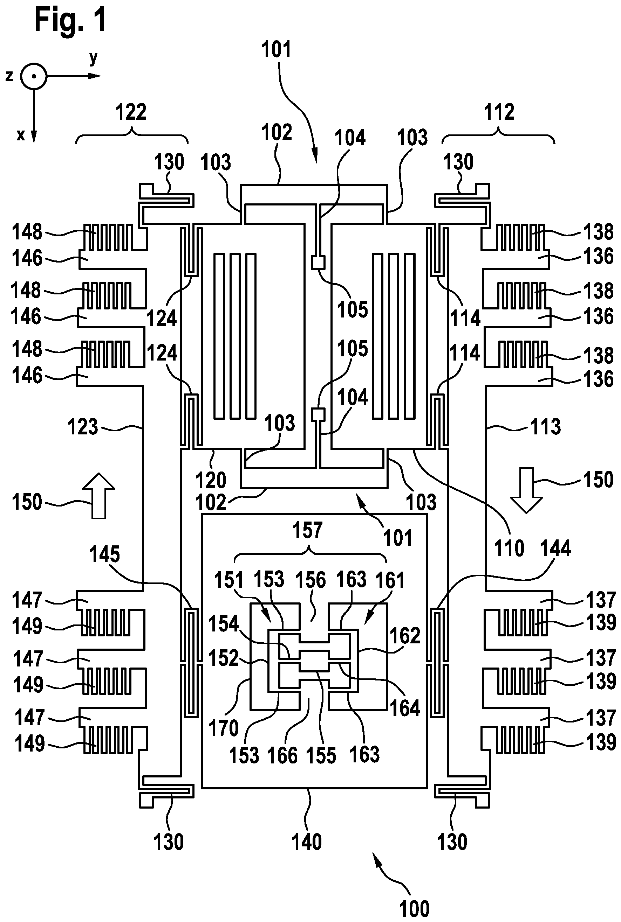

Fig. 1 zeigt einen Drehratensensor 100 gemäß einer beispielhaften Ausführungsform der Erfindung. Bei Fig. 1 handelt es sich um eine Aufsicht auf ein nicht näher dargestelltes Substrat mit einer Haupterstreckungsebene (x-y-Ebene), in der zwischen einem ersten Antriebsbalken 113 und einem zweiten Antriebsbalken 123 ein erstes Coriolis-Element 110, ein zweites Coriolis-Element 120 und ein Rotationsschwinger 140 angeordnet sind. Wie in der linken oberen Ecke von Fig. 1 graphisch angegeben ist, weist in Fig. 1 die x-Richtung von oben nach unten, die y-Richtung von links nach rechts und die z-Richtung aus der Zeichenebene zum Betrachter.

Das erste und zweite Coriolis-Element 110, 120 sind als rechteckige, rahmenförmige Strukturen gleicher Form und Größe ausgebildet, die mit ihren Langseiten parallel zur x-Richtung ausgerichtet und nebeneinander angeordnet sind, sodass eine Langseite des ersten Coriolis-Elements 110 und eine Langseite des zweiten Coriolis-Elements 120 durch einen Spalt beabstandet einander gegenüberliegen, wobei die Kurzseiten der Coriolis-Elemente 110, 120 paarweise miteinander fluchten. Die Rahmenstruktur der Coriolis-Elemente 110, 120 ergibt sich daraus, dass sie in der Nähe der voneinander abgekehrten Langseiten jeweils einen gitterartigen Gewichtsverringerungsbereich aufweisen, in dem längs verlaufende, nur durch dünne Stege voneinander getrennte Aussparungen gebildet sind.

An den beiden Paaren ihrer miteinander fluchtenden, benachbarten Kurzseiten sind die Coriolis-Elemente 110, 120 durch zwei spiegelsymmetrische Kopplungsglieder 101 beweglich miteinander gekoppelt. Jedes Kopplungsglied 101 umfasst einen Wippbalken 102, der sich neben dem ersten und zweiten Coriolis-Element 110, 120 parallel zu den miteinander fluchtenden Kurzseiten erstreckt, wobei je ein Ende des Wippbalkens 102 der Mitte einer Kurzseite gegenüberliegt. An den beiden Enden seines Wippbalkens 102 weist das Kopplungsglied 101 jeweils einen Kopplungsfederstab 103 auf, der das Ende des Wippbalkens 102 auf kürzestem Wege mit der Mitte der gegenüberliegenden Kurzseite des entsprechenden Coriolis-Elements federnd verbindet. Ferner beinhaltet das Kopplungsglied 101 einen Wippfederstab 104, der sich von der Mitte des Wippbalkens 102, die dem Spalt zwischen den Coriolis-Elementen 110, 120 gegenüberliegt, bis zu einem im Spalt gelegenen Substratverankerungspunkt 105 erstreckt, um den Wippbalken 102 federnd mit dem Substrat zu verbinden.

Die einzelnen Kopplungsglieder 101 weisen somit insgesamt die Gestalt eines "E" auf, wobei der Wippfederstab 104 in der vorliegenden Ausführungsform länger als die Kopplungsfederstäbe 103 ausgebildet ist. Beispielsweise hat der Wippfederstab 104 die zwei- bis dreifache Länge der Kopplungsfederstäbe 103. Gegenüber der der Langseite des ersten Coriolis-Elements 110, die vom zweiten Coriolis-Element 120 entfernt gelegen ist, erstreckt sich in der x-Richtung der erste Antriebsbalken 113. Die beiden Ecken des Coriolis-Elements 110 an dieser Langseite sind mit je einer dritten Feder 114 federnd an den Antriebsbalken 113 gekoppelt. Der Antriebsbalken 113 selbst ist an seinen beiden Enden mit je einer Aufhängefeder 130, die jeweils näher zur von den Coriolis-Elementen 110, 120 abgewandten Seite des ersten Antriebsbalkens 113 angebunden ist, derart federnd an einem mit dem Substrat fest verbundenen Substratverankerungspunkt aufgehängt, dass er in der x-Richtung schwingend beweglich ist.

An der von den Coriolis-Elementen 110, 120 abgewandten Seite des ersten Antriebsbalkens 113 sind eine Vielzahl erster Antriebselektrodenträger 136, 137 ausgebildet, die sich vom ersten Antriebsbalken 113 in Richtung der zu den Coriolis-Elementen 110, 120 entgegengesetzten Seite abstrecken und im Wesentlichen parallel zur y-Richtung verlaufen. Jeder der ersten Antriebselektrodenträger 136, 137 trägt eine Vielzahl von ersten Antriebselektroden 138, 139, die parallel zur x-Richtung ausgedehnt sind. In der vorliegenden Ausführungsform sei beispielhaft angenommen, dass der Antriebsbalken 113 ein-schließlich der Antriebselektrodenträger 136, 137 und der Antriebselektroden 138, 139 eine konstante Dicke in der z-Richtung aufweist, die größer als die Breite der Antriebselektroden 138, 139 in der y-Richtung ist und z.B. gleich der Breite des Antriebsbalkens 113 in der y-Richtung sein kann. Damit weisen die einzelnen Antriebselektroden 138, 139 eine flächenhafte Ausdehnung parallel zur x- und z-Richtung auf.

In der vorliegenden Ausführungsform sind entlang des ersten Antriebsbalkens 113 mehrere erste Antriebselektrodenträger 136, 137 vorgesehen, wobei eine Hälfte der Antriebselektrodenträger 136 zu einem Ende des ersten Antriebsbalkens 113 hin gruppiert angeordnet ist und die andere Hälfte der Antriebselektrodenträger 137 zum anderen Ende des ersten Antriebsbalkens 113 hin gruppiert angeordnet ist. Zwischen den beiden Gruppen befindet sich in der Mitte des ersten Antriebsbalkens 113 ein von Antriebselektrodenträgern freier Abschnitt. Die jeweiligen Antriebselektroden 138, 139 an den beiden Gruppen von Antriebselektrodenträgern 136, 137 weisen jeweils zur Seite des nächstgelegenen Endes des ersten Antriebsbalkens 113.

Spiegelsymmetrisch zum ersten Antriebsbalken 113 erstreckt sich gegenüber der Langseite des zweiten Coriolis-Elements 120, die vom ersten Coriolis-Element 110 entfernt gelegen ist, der zweite Antriebsbalken 123. Die beiden Ecken des zweiten Coriolis-Elements 120 an dieser Langseite sind mit je einer vierten Feder 124 federnd an den zweiten Antriebsbalken 123 gekoppelt. An der von den Coriolis-Elementen 110, 120 abgewandten Seite des zweiten Antriebsbalkens 123 sind eine Vielzahl zweiter Antriebselektrodenträger 146, 147 ausgebildet, die sich vom zweiten Antriebsbalken 123 in der zu den Coriolis-Elementen 110, 120 entgegengesetzten Richtung abstrecken. Jeder zweite Antriebselektrodenträger 146, 147 trägt eine Vielzahl von ersten Antriebselektroden 148, 149. Wegen der Spiegelsymmetrie der aus dem ersten Antriebsbalken 113, den dritten Federn 114 und dem ersten Coriolis-Element 110 bestehenden Anordnung mit der aus dem zweiten Antriebsbalken 123, den vierten Federn 124 und dem zweiten Corio-lis-Element 120 bestehenden Anordnung wird zu weiteren Details auf die obigen Ausführungen zum ersten Antriebsbalken 113 verwiesen.

In der vorliegenden Ausführungsform fluchten die beiden Antriebsbalken 113, 123 jeweils bündig mit einem Ende der Langseiten der Coriolis-Elemente 110, 120, ragen dagegen über das andere Ende hinaus, wobei in dem neben den Coriolis-Elementen 110, 120 gebildeten weiteren Raum zwischen den Antriebsbalken 113, 123 der Rotationsschwinger 140 angeordnet ist. Mit einer ersten und zweiten Feder 144, 145 ist der Rotationsschwinger 140 an den ersten beziehungsweise zweiten Antriebsbalken 113, 123 gekoppelt. In der vorliegenden Ausführungsform weist der Rotationsschwinger 140 eine rechteckige Umrissgestalt auf, deren Langseiten nur geringfügig länger als die Kurzseiten gebildet sind und jeweils zu einem der Antriebsbalken 113, 123 parallel verlaufend diesem unter Bildung eines Spaltes gegenüberliegen. Dies ermöglicht eine besonders kompakte Bauweise des Drehratensensors und Ausnutzung des Bauraums. In alternativen Ausführungsformen kann der Rotationsschwinger 140 z.B. quadratisch, kreisförmig oder elliptisch gestaltet sein.

An einer Achsposition des Rotationsschwingers 140, die sich nahe des geometrischen Zentrums des Rotationsschwingers 140 befindet, ist ein Rotationsschwinglager 157 gebildet, welches den Rotationsschwinger 140 schwingend drehbar um eine in der z-Richtung durch einen Substratverankerungspunkt 155 durch die Achsposition verlaufende Rotationsschwingachse abstützt. Angemerkt wird, dass in alternativen Ausführungsformen die Achsposition sich auch exakt im geometrischen Zentrum des Rotationsschwingers 140 oder einer anderen Position befinden kann, sofern der Rotationsschwinger 140 eine schwingende Drehbewegung um die durch die Achsposition verlaufende Rotationsschwingachse ausführen kann. Vorzugsweise liegt der Schwerpunkt des Rotationsschwingers 140 an der Achsposition. Das Rotationsschwinglager 157 umfasst eine wesentlich mittige rechteckige Aussparung 170 im Rotationsschwinger 140, innerhalb derer sich der Substratverankerungspunkt 155 befindet. Ein erster und ein zweiter Steg 156, 166 erstrecken sich von zwei gegenüberliegenden Rändern der Aussparung 170 in Richtung des Substratverankerungspunkts 155, wobei zwischen dem distalen Ende jedes Stegs 156, 166 und dem Substratverankerungspunkt 155 jeweils ein Abstand verbleibt.

In den zu beiden Seiten der Stege 156, 166 verbleibenden Bereichen der Aussparung 170 weist das Rotationsschwinglager 157 ein erstes und zweites Lagerungsglied 151, 161 auf, von denen jedes die Stege 156, 166 und den Substratverankerungspunkt 155 miteinander verbindet. Jedes Lagerungsglied 151, 161 umfasst einen Wippbalken 152, 162, der sich neben den Stegen 156, 166 und dem Substratverankerungspunkt 155 parallel zu den miteinander fluchtenden Stegen 156, 166 erstreckt, wobei je ein Ende des Wippbalkens 152, 162 dem Ende eines Steges 156, 166 gegenüberliegt. An den beiden Enden seines Wippbalkens 152, 162 weist jedes Lagerungsglied 151, 161 jeweils einen Lagerungsfederstab 153 auf, der das Ende des Wippbalkens 152 auf kürzestem Wege mit dem zugehörigen Steg 156 federnd verbindet. Ferner beinhaltet jedes Lagerungsglied 151, 161 einen Wippfederstab 154, 164 der sich von der Mitte des zugehörigen Wippbalkens 152, 162, die jeweils dem Substratverankerungspunkt 155 gegenüberliegt, bis zum Substratverankerungspunkt 155 erstreckt, um den betreffenden Wippbalken 152, 162 federnd mit dem Substrat zu verbinden. Die einzelnen Lagerungsglieder 151, 161 weisen somit, ähnlich wie die Kopplungsglieder 101, 102 insgesamt die Gestalt eines "E" auf, wobei die Wippfederstäbe 154, 164 und die Lagerungsfederstäbe 153, 163 in der vorliegenden Ausführungsform gleich lang ausgebildet sind.

Im Betrieb des mikromechanischen Drehratensensors 100 werden die Antriebselektroden 138, 139, 148, 149 und zugehörige statische Elektroden (nicht gezeigt), die gegenüber dem Substrat, zu welchem auch die Substratverankerungspunkte 105, 155 zählen, unbeweglich sind und sich mit den Antriebselektroden 138, 139, 148, 149 jeweils kämmen, derart koordiniert mit unterschiedlichen, zeitlich wechselnden elektrischen Spannungen beaufschlagt, dass die Antriebsbalken 113, 123 in eine antiparallele Antriebsmode 150 versetzt werden, in der sie entlang der x-Achse eine zueinander um 180° phasenversetzte Schwingbewegung ausführen.

Beispielsweise werden, während die Antriebsbalken 113 mit den Antriebselektroden 138, 139, 148, 149 auf einem konstantem Massepotential gehalten werden, mittels einer elektronischen Steuervorrichtung (nicht gezeigt) zunächst die statischen Elektroden, die sich mit den zur Seite der Coriolis-Elemente 110, 120 (in Fig. 1 nach oben) weisenden Antriebselektroden 138 am ersten Antriebsbalken 113 kämmen, und die statischen Elektroden, die sich mit den zur entgegengesetzten Seite des Rotationsschwingers 140 (in Fig. 1 nach unten) weisenden Antriebselektroden 149 am zweiten Antriebsbalken 123 kämmen, mit einer elektrischen Spannung gegenüber Masse beaufschlagt, sodass der erste Antriebsbalken 113 durch die elektrostatischen Kräfte in der in Fig. 1 nach oben weisenden Richtung beschleunigt wird, während der zweite Antriebsbalken 123 durch die elektrostatischen Kräfte in der in Fig. 1 nach unten weisenden Richtung beschleunigt wird. Anschließend wird die angelegte Spannung abgeschaltet, worauf die Antriebsbalken 113, 123 durch die Rückstellkraft der Aufhängefedern 130 verzögert und wieder in Richtung der Ausgangsstellung beschleunigt werden.

Nachfolgend werden die statischen Elektroden, die sich mit den in Fig. 1 nach oben weisenden Antriebselektroden 148 am zweiten Antriebsbalken 123 kämmen, und die statischen Elektroden, die sich mit den in Fig. 1 nach unten weisenden Antriebselektroden 139 am ersten Antriebsbalken 113 kämmen, mit einer elektrischen Spannung gegenüber Masse beaufschlagt, sodass der erste Antriebsbalken 113 durch die elektrostatischen Kräfte in der in Fig. 1 nach unten weisenden Richtung beschleunigt wird, während der zweite Antriebsbalken 123 durch die elektrostatischen Kräfte in der in Fig. 1 nach oben weisenden Richtung beschleunigt wird. Anschließend wird die angelegte Spannung wieder abgeschaltet, worauf die Antriebsbalken 113, 123 durch die Rückstellkraft der Aufhängefedern 130 zunächst verzögert und dann in Richtung der Ausgangsstellung beschleunigt werden.

Hierbei kann die obige Ansteuerung in vorteilhafter Weise mit einer zeitlichen Periode wiederholt werden, die im Wesentlichen mit der Eigenfrequenz der antiparallelen Schwingungsmode 150 übereinstimmt, in welcher eine aus dem ersten Antriebsbalken 113, den ersten Antriebselektrodenträgern 136, 137 und den ersten Antriebselektroden 138, 139 bestehende erste Antriebsmasse 112 und eine aus dem zweiten Antriebsbalken 123, den zweiten Antriebselektrodenträgern 146, 147 und den zweiten Antriebselektroden 148, 149 bestehende zweite Antriebsmasse 122 gegenphasig entlang der x-Achse schwingen. In dieser Antriebsmode 150 führt das erste Coriolis-Element 110 aufgrund der Ankopplung über die dritten Federn 114 eine Schwingbewegung aus, die zur ersten Antriebsmasse 112 um einen konstanten Winkel phasenversetzt (z.B. gleichphasig) ist, während das zweite Coriolis-Element aufgrund der Ankopplung über die vierten Federn 124 eine Schwingbewegung ausführt, die zur zweiten Antriebsmasse 122 - z.B. bei symmetrischer Ausbildung und Ansteuerung wie in der vorliegenden Ausführungsform - um ebenfalls den konstanten Winkel phasenversetzt ist. Dies bedeutet, dass das erste Coriolis-Element 110 und das zweite Coriolis-Element 120 eine antiparallele Schwingbewegung in zum Antriebsbalken paralleler Richtung ausführen, welche durch die mechanische Kopplung über die Kopplungsglieder 101, 102 zusätzlich stabilisiert wird.

In der obigen antiparallelen Antriebsmode 150 wird der Rotationsschwinger 140 aufgrund dessen Ankopplung über die erste und zweite Feder 144, 145 in eine schwingende Drehbewegung um die in z-Richtung durch den Substratverankerungspunkt 155 des Rotationsschwinglagers 157 verlaufende Achse versetzt. Über einerseits die erste Feder 144, den Rotationsschwinger 140 und die zweite Feder 145 sowie andererseits die dritten Federn 114, das erste Coriolis-Element 110, die Kopplungsglieder 101, das zweite Coriolis-Element 120 und die vierten Federn 124 ergibt sich eine mechanische Kopplung zwischen den Schwingbewegungen der ersten und zweiten Antriebsmasse 112, 122, welche die antiparallele Antriebsmode 150 stabilisiert.

Wenn der Drehratensensor 100 bei fortgesetzter Ausführung der antiparallelen Antriebsmode 150 um die x-Achse gedreht wird, wirkt auf den Rotationsschwinger 140 ein Drehmoment, das den Rotationsschwinger 140 um die durch die erste und zweite Feder 144, 145, den Substratverankerungspunkt 155 sowie die Wippfederstäbe 154, 164 der Lagerungsglieder 151, 161 gehende Verkippungsachse aus der Haupterstreckungsebene auslenkt.

Wird der Drehratensensor 100 um die y-Achse gedreht, wirken auf die Coriolis-Elemente 110, 120 Kräfte, die diese in zueinander entgegengesetzter Richtung aus der Haupterstreckungsebene auslenken. Dabei erfolgt durch Verkippen der Wippbalken 102 der Kopplungsglieder 101 um die zugehörigen Wippfederstäbe 104 eine stabilisierende mechanische Kopplung zwischen den Auslenkungen der beiden Coriolis-Elemente 110, 120.

Wird der Drehratensensor 100 um die z-Achse gedreht, wirken auf die Coriolis-Elemente 110, 120 Kräfte, die diese in zueinander entgegengesetzter Richtung parallel zur y-Achse auslenken. Dabei erfolgt durch Biegen der Kopplungsfederstäbe 103 eine stabilisierende mechanische Kopplung zwischen den Auslenkungen der beiden Coriolis-Elemente 110, 120. Eine Detektion der Auslenkungen der Coriolis-Elemente 110, 120 und des Rotationsschwingers 140 kann in den obigen Fällen kann jeweils über Kapazitätsveränderungen an geeignet positionierten Messelektroden (nicht gezeigt) erfolgen.

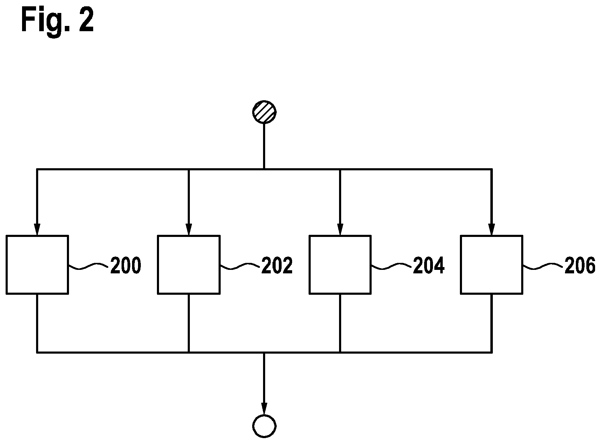

Fig. 2 zeigt ein Flussdiagramm für ein Verfahren zum Herstellen eines mikromechanischen Drehratensensors mit einem Rotationsschwinger, wie z.B. des vorstehend beschriebenen Drehratensensors 100 aus Fig. 1, welches das Ausbilden eines Rotationsschwinglagers für den Rotationsschwinger umfasst.

In Schritt 200-206 wird der Drehratensensor mittels eines mikromechanischen Prozesses hergestellt, welcher unterschiedliche Elemente des Drehratensensors gleichzeitig ausbildet. Im Einzelnen wird in Schritt 200 der Rotationsschwinger ausgebildet, während in den gleichzeitig mit Schritt 200 erfolgenden Schritten 202, 204, 206 das Rotationsschwinglager ausgebildet wird. In Schritt 202 wird ein Wippbalken ausgebildet. In Schritt 204 wird der Wippbalken mittels eines Wippfederstabs federnd mit einem Substrat des Drehratensensors verbunden. In Schritt 206 werden der Wippbalken und der Rotationsschwinger mittels zweier Lagerungsfederstäbe auf entgegengesetzten Seiten des Wippfederstabs federnd verbunden.

Abhängig von der genauen Gestalt des Drehratensensors umfasst das Verfahren die Herstellung weiterer Bestandteile. Beispielsweise kann im Falle der Herstellung des Drehratensensors 100 aus Fig. 1 vorgesehen sein, dass in Schritt 200 ein erster und zweiter Antriebsbalken ausgebildet werden, die entlang entgegengesetzter Seiten des Rotationsschwingers angeordnet sind, über zugehörige Federn an den Rotationsschwinger gekoppelt sind sowie Antriebselektroden tragen. Für das Rotationsschwinglager kann in Schritt 202 noch ein weiterer Wippbalken ausgebildet und in Schritt 204 der weitere Wippbalken mittels eines zugehörigen weiteren Wippfederstabs federnd mit dem Substrat verbunden werden. In Schritt 206 können sowohl der Wippbalken als auch der weitere Wippbalken mittels jeweils zweier Lagerungsfederstäbe auf entgegengesetzten Seiten des betreffenden Wippfederstabs federnd mit dem Rotationsschwinger verbunden werden.

Vor und nach dem mikromechanischen Prozess der Schritte 200-206 können weitere Verfahrensschritte vorgesehen sein. Angemerkt wird, dass in Fig. 2 die Schritte 200-206 zwar als gleichzeitig erfolgend dargestellt sind, in alternativen Ausführungsformen im Rahmen eines geeigneten mikromechanischen oder sonstigen Herstellungsverfahrens aber auch z.B. nacheinander durchgeführt werden können.

## Patentansprüche

1. Mikromechanischer Drehratensensor (100), aufweisend einen Rotations-schwinger (140) mit einem Rotationsschwinglager (157), welches umfasst:
einen Wippbalken (152);
einen Wippfederstab (154), der den Wippbalken (152) federnd mit einem Substrat (155) des Drehratensensors (100) verbindet; und
zwei Lagerungsfederstäbe (153), die auf entgegengesetzten Seiten des Wippfederstabs (154) den Wippbalken (152) federnd mit dem Rotationsschwinger (140) verbinden, wobei der Wippfederstab (154) senkrecht zum Wippbalken (152) verläuft, **dadurch gekennzeichnet, dass** die Lagerungsfederstäbe (153) parallel zum Wippfederstab (154) verlaufen.

2. Drehratensensor (100) nach Anspruch 1, wobei die Lagerungsfederstäbe (153) symmetrisch auf den entgegengesetzten Seiten des Wippfederstabs (154) ausgebildet sind.

3. Drehratensensor (100) nach einem der vorhergehenden Ansprüche, ferner umfassend:
eine erste Antriebsmasse (112), welche neben dem Rotationsschwinger (140) angeordnet und über eine erste Feder (144) an den Rotationsschwinger (140) gekoppelt ist; sowie
eine zweite Antriebsmasse (122), welche neben dem Rotationsschwinger (140) angeordnet und über eine zweite Feder (145) an den Rotationsschwinger (140) gekoppelt ist;
wobei der Wippfederstab (154) sich entlang einer Verbindungsgerade zwischen der ersten und zweiten Feder (144, 145) erstreckt.

4. Drehratensensor (100) nach einem der vorhergehenden Ansprüche, wobei das Rotationsschwinglager (157) ferner umfasst:
einen weiteren Wippbalken (162);
einen weiteren Wippfederstab (164), welcher den weiteren Wippbalken (162) federnd mit dem Substrat (155) des Drehratensensors (100) verbindet; und
zwei weitere Lagerungsfederstäbe (163), welche auf entgegengesetzten Seiten des weiteren Wippfederstabs (164) den weiteren Wippbalken (162) federnd mit dem Rotationsschwinger (140) verbinden.

5. Drehratensensor (100) nach Anspruch 4, wobei der Wippfederstab (154) und der weitere Wippfederstab (164) kollinear ausgebildet sind.

6. Drehratensensor (100) nach einem der vorhergehenden Ansprüche, wobei:
der Rotationsschwinger (140) einen ersten Vorsprung (156) und einen zweiten Vorsprung (166) des Rotationsschwingers (140) aufweist;
die Lagerungsfederstäbe (153) den Wippbalken (152) mit dem ersten beziehungsweise zweiten Vorsprung (156, 166) verbinden; und
die weiteren Lagerungsfederstäbe (163) den weiteren Wippbalken (162) mit dem ersten beziehungsweise zweiten Vorsprung (156, 166) verbinden.

7. Drehratensensor (100) nach Anspruch 6, wobei:
der erste und zweite Vorsprung (156, 166) an einander gegenüberliegenden Seiten einer Aussparung (170) des Rotationsschwingers (140) gebildet sind; sowie
der Wippfederstab (154) den Wippbalken (152) und der weitere Wippfederstab (164) den weiteren Wippbalken (162) mit dem Substrat (155) des Drehratensensors (100) zwischen dem ersten und zweiten Vorsprung (156, 166) verbindet.

8. Verfahren zum Herstellen eines Mikromechanischen Drehratensensors (100) mit einem Rotationsschwinger (140), welches das Ausbilden eines Rotationsschwinglagers (157) mit folgenden Schritten umfasst:
Ausbilden (200) eines Wippbalkens (152);
Federndes Verbinden (202) des Wippbalkens (152) und eines Substrats (155) des Drehratensensors (100) mittels eines Wippfederstabs (154); und
Federndes Verbinden (204) des Wippbalkens (152) und des Rotationsschwingers (140) mittels zweier Lagerungsfederstäbe (153) auf entgegengesetzten Seiten des Wippfederstabs (154) derart, dass der Wippfederstab (154) senkrecht zum Wippbalken (152) verläuft, **dadurch gekennzeichnet, dass** die Lagerungsfederstäbe (153) parallel zum Wippfederstab (154) verlaufen.

## Claims

1. Micromechanical yaw rate sensor (100), having a rotationally oscillating mass (140) with a rotationally oscillating mass bearing (157), which comprises:
a rocker bar (152);
a rocker spring rod (154), which resiliently connects the rocker bar (152) to a substrate (155) of the yaw rate sensor (100); and
two support spring rods (153), which resiliently connect the rocker bar (152) to the rotationally oscillating mass (140) on opposite sides of the rocker spring rod (154) wherein the rocker spring rod (154) extends at right angles to the rocker bar (152), **characterized in that** the support spring rods (153) extend parallel to the rocker spring rod (154).

2. Yaw rate sensor (100) according to Claim 1, wherein the support spring rods (153) are formed symmetrically on the opposite sides of the rocker spring rod (154).

3. Yaw rate sensor (100) according to either of the preceding claims, further comprising:
a first drive mass (112), which is arranged beside the rotationally oscillating mass (140) and is coupled to the rotationally oscillating mass (140) via a first spring (144); and
a second drive mass (122), which is arranged beside the rotationally oscillating mass (140) and is coupled to the rotationally oscillating mass (140) via a second spring (145) ;
wherein the rocker spring rod (154) extends along a connecting straight line between the first and second spring (144, 145).

4. Yaw rate sensor (100) according to one of the preceding claims, wherein the rotationally oscillating mass bearing (157) further comprises:
a further rocker bar (162);
a further rocker spring rod (164), which resiliently connects the further rocker bar (162) to the substrate (155) of the yaw rate sensor (100); and
two further support spring rods (163), which resiliently connect the further rocker bar (162) to the rotationally oscillating mass (140) on opposite sides of the further rocker spring rod (164).

5. Yaw rate sensor (100) according to Claim 4, wherein the rocker spring rod (154) and the further rocker spring rod (164) are formed collinearly.

6. Yaw rate sensor (100) according to one of the preceding claims, wherein:
the rotationally oscillating mass (140) has a first projection (156) and a second projection (166) of the rotationally oscillating mass (140);
the support spring rods (153) connect the rocker bar (152) to the first and second projection (156, 166) respectively; and
the further support spring rods (163) connect the further rocker bar (162) to the first and second projection (156, 166) respectively.

7. Yaw rate sensor (100) according to Claim 6, wherein:
the first and second projection (156, 166) are formed on mutually opposite sides of a cut-out (170) of the rotationally oscillating mass (140); and
the rocker spring rod (154) connects the rocker bar (152) and the further rocker spring rod (164) connects the further rocker bar (162) to the substrate (155) of the yaw rate sensor (100) between the first and second projection (156, 166).

8. Method for producing a micromechanical yaw rate sensor (100) having a rotationally oscillating mass (140), which comprises the formation of a rotationally oscillating mass bearing (157) with the following steps:
forming (200) a rocker bar (152);
resiliently connecting (202) the rocker bar (152) and a substrate (155) of the yaw rate sensor (100) by means of a rocker spring rod (154); and
resiliently connecting (204) the rocker bar (152) and the rotationally oscillating mass (140) by means of two support spring rods (153) on opposite sides of the rocker spring rod (154) such that the rocker spring rod (154) extends at right angles to the rocker bar (152), **characterized in that** the support spring rods (153) extend parallel to the rocker spring rod (154).

## Revendications

1. Capteur de vitesse de rotation (100) micromécanique, comprenant un oscillateur à rotation (140) doté d'un palier d'oscillation de rotation (157) qui comporte :
une barre basculante (152) ;
une tige de ressort basculante (154) qui relie la barre basculante (152) avec effet de ressort à un substrat (155) du capteur de vitesse de rotation (100) ; et
deux tiges de ressort de support (153), qui relient la barre basculante (152) avec effet de ressort à l'oscillateur à rotation (140) sur des côtés opposés de la tige de ressort basculante (154), la tige de ressort basculante (154) s'étendant perpendiculairement à la barre basculante (152),
**caractérisé en ce que**
les tiges de ressort de support (153) s'étendent parallèlement à la tige de ressort basculante (154).

2. Capteur de vitesse de rotation (100) selon la revendication 1, les tiges de ressort de support (153) étant de configuration symétrique sur les côtés opposés de la tige de ressort basculante (154).

3. Capteur de vitesse de rotation (100) selon l'une des revendications précédentes, comprenant en outre :
une première masse d'entraînement (112), laquelle est disposée à côté de l'oscillateur à rotation (140) et accouplée à l'oscillateur à rotation (140) par le biais d'un premier ressort (144) ; et
une deuxième masse d'entraînement (122), laquelle est disposée à côté de l'oscillateur à rotation (140) et accouplée à l'oscillateur à rotation (140) par le biais d'un deuxième ressort (145) ;
la tige de ressort basculante (154) s'étendant le long d'une droite de liaison entre les premier et deuxième ressorts (144, 145).

4. Capteur de vitesse de rotation (100) selon l'une des revendications précédentes, le palier d'oscillation de rotation (157) comprenant en outre :
une barre basculante supplémentaire (162) ;
une tige de ressort basculante supplémentaire (164) qui relie la barre basculante supplémentaire (162) avec effet de ressort au substrat (155) du capteur de vitesse de rotation (100) ; et
deux tiges de ressort de support supplémentaires (163), qui relient la barre basculante supplémentaire (162) avec effet de ressort à l'oscillateur à rotation (140) sur des côtés opposés de la tige de ressort basculante supplémentaire (164).

5. Capteur de vitesse de rotation (100) selon la revendication 4, la tige de ressort basculante (154) et la tige de ressort basculante supplémentaire (164) étant de configuration colinéaire.

6. Capteur de vitesse de rotation (100) selon l'une des revendications précédentes, l'oscillateur à rotation (140) possédant une première partie saillante (156) et une deuxième partie saillante (166) de l'oscillateur à rotation (140) ;
les tiges de ressort de support (153) reliant la barre basculante (152) à la première ou la deuxième partie saillante (156, 166) ; et
les tiges de ressort de support supplémentaires (163) reliant la barre basculante supplémentaire (162) à la première ou la deuxième partie saillante (156, 166).

7. Capteur de vitesse de rotation (100) selon la revendication 6,
la première et la deuxième partie saillante (156, 166) étant formées sur des côtés mutuellement opposés d'une cavité (170) de l'oscillateur à rotation (140) ; et
la tige de ressort basculante (154) reliant la barre basculante (152), et la tige de ressort basculante supplémentaire (164) reliant la barre basculante supplémentaire (162) au substrat (155) du capteur de vitesse de rotation (100) entre la première et la deuxième partie saillante (156, 166).

8. Procédé de fabrication d'un capteur de vitesse de rotation (100) micromécanique, comprenant un oscillateur à rotation (140), lequel comprend la formation d'un palier d'oscillation de rotation (157) avec les étapes suivantes :
formation (200) d'une barre basculante (152) ;
liaison avec effet de ressort (202) de la barre basculante (152) et d'un substrat (155) du capteur de vitesse de rotation (100) au moyen d'une tige de ressort basculante (154) ; et
liaison avec effet de ressort (204) de la barre basculante (152) et de l'oscillateur à rotation (140) au moyen de deux tiges de ressort de support (153) sur des côtés opposés de la tige de ressort basculante (154) de telle sorte que la tige de ressort basculante (154) s'étend perpendiculairement à la barre basculante (152),
**caractérisé en ce que**
les tiges de ressort de support (153) s'étendent parallèlement à la tige de ressort basculante (154).
